(19) **Europäisches Patentamt / European Patent Office / Office européen des brevets**

(11) **EP 3 295 480 B1**

(12) **FASCICULE DE BREVET EUROPEEN**

(45) Date de publication et mention
de la délivrance du brevet:
**21.04.2021 Bulletin 2021/16**

(21) Numéro de dépôt: **16722214.0**

(22) Date de dépôt: **12.05.2016**

(51) Int Cl.:
***H01L 21/762*** *(2006.01)*

(86) Numéro de dépôt international:
**PCT/EP2016/060653**

(87) Numéro de publication internationale:
**WO 2016/180917 (17.11.2016 Gazette 2016/46)**

(54) **PROCÉDÉ DE COLLAGE DIRECT**

VERFAHREN ZUM DIREKTEN BONDEN

METHOD FOR DIRECT BONDING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.05.2015 FR 1554312**

(43) Date de publication de la demande:
**21.03.2018 Bulletin 2018/12**

(73) Titulaire: **Commissariat à l'Énergie Atomique
et aux Énergies Alternatives
75015 Paris (FR)**

(72) Inventeurs:
  • **TAUZIN, Aurélie
38120 St Egreve (FR)**
  • **IMBERT, Bruno
38000 Grenoble (FR)**

(74) Mandataire: **Delorme, Nicolas et al
Cabinet Germain & Maureau
BP 6153
69466 Lyon Cedex 06 (FR)**

(56) Documents cités:
**EP-A1- 1 635 396     EP-A1- 1 664 396
EP-A1- 1 881 528**

  • **U. GÖSELE ET AL: "SEMICONDUCTOR WAFER
BONDING", ANNUAL REVIEW OF MATERIALS
SCIENCE, vol. 28, no. 1, 1 août 1998 (1998-08-01),
- 31 août 1998 (1998-08-31), pages 215-241,
XP055032047, ISSN: 0084-6600, DOI:
10.1146/annurev.matsci.28.1.215**

EP 3 295 480 B1

## Description

La présente invention concerne un procédé de collage direct amélioré entre substrats de matériaux différents, choisis parmi des alliages d'éléments des colonnes III et V et notamment un procédé de collage direct entre des substrats d'InP et de GaAs.

L'intégration de différents matériaux à base d'InP et de GaAs n'est pas réalisable sans défauts, directement par les techniques de croissance épitaxiale, à cause des différences de propriétés de ces matériaux (différence de dilatation thermique et de paramètre de maille). Une alternative est un collage direct d'InP et de GaAs permettant l'obtention d'un empilement vertical de ces matériaux et la réalisation d'hétérostructures nouvelles, sans dégradation des propriétés des matériaux.

Le collage direct d'InP et de GaAs est relativement connu dans la littérature, et différentes conditions d'assemblage ont été décrites (collage à chaud, collage sous vide,...).

Lors d'un report de film mince d'un matériau à base d'InP ou de GaAs, les défauts microscopiques et macroscopiques présents au niveau de l'interface de collage ont une très grande importance, car ils peuvent entraîner une forte défectivité du film mince transféré, sous forme de soulèvements du film voire de détachements locaux. Ces problèmes de collage ont été reportés dans le document {Solid-State Electronics 46 (2002) 1103-1108} décrivant la formation de bulles sur un film mince d'InP reporté sur un substrat GaAs par collage direct. Pour éviter la formation de ces bulles, les auteurs proposent de réaliser des tranchées dans le film mince de sorte à favoriser l'élimination des produits de réaction gazeux du collage. Cette approche présente de nombreux inconvénients : la couche active (film mince d'InP) transférée est discontinue, ce qui peut la rendre incompatible avec certains dispositifs. De plus des étapes de photolithographies coûteuses sont nécessaires et la partie gravée de la couche active pour former les tranchées est perdue Le document U. GOSELE ET AL: "SEMICONDUCTOR WAFER BONDING",ANNUAL REVIEW OF MATERIALS SCIENCE, vol. 28, no. 1, 1 août 1998 (1998-08-01), - 31 août 1998 (1998-08-31), pages 215-241, décrit un procédé de collage de couches de GaAs et InP et ses problèmes liés à la formation de bulles à l'interface.

Dans le cadre de la réalisation de cellules photovoltaïque à concentration (CPV) à quatre jonctions, les étapes suivantes ont été proposées par F. Dimroth et al. (dans "Wafer bonded four-junction GaInP/GaAs//GaInAsP/GaInAs concentrator solar cells with 44.7% efficiency", Prog. Photovolt: Res. Appl., 2014) :

- deux jonctions sont épitaxiées sur un premier substrat de GaAs
- deux jonctions sont épitaxiées sur un second substrat d'InP
- les 4 jonctions sont assemblées par collage direct d'alliages III-V (par exemple InP//GaAs)
- les 4 jonctions sont reportées sur le second substrat d'InP après élimination du premier substrat de GaAs.

L'élimination du premier substrat GaAs peut être effectuée par amincissement chimique ou mécanique ou par la technique du laser lift-off dans le cas où le premier substrat est un substrat GaAsOS (GaAs-On-Sapphire, réalisé par Smart Cut™). La qualité de l'interface de collage InP-GaAs est alors critique pour l'obtention de jonctions reportées homogènes et sans défaut.

De la même façon, la réalisation d'un substrat composite constitué d'un film mince d'InP reporté sur un substrat GaAs par Smart Cut™ utilise une étape de collage direct InP//GaAs qui influence directement la qualité du film d'InP transféré. Ce type de substrat InPOGaAs (pour InP-On-GaAs) est particulièrement intéressant en remplacement du substrat InP massif très coûteux utilisé pour la réalisation de cellules solaires CPV à 4 jonctions. Les éventuels défauts de collage entraînent des défauts de transfert dans le film d'InP, qui se répercutent dans les jonctions épitaxiées sur le substrat d'InPOGaAs et dans l'assemblage final des 4 jonctions. Il est donc primordial de préserver l'interface de collage de tout défaut.

Classiquement la problématique des défauts de collage est traitée par l'adaptation des étapes technologiques réalisées sur les surfaces avant leur mise en contact : nettoyage, plasma, rinçage, séchage,...Dans certains cas, le mode de mise en contact peut aussi influencer la qualité des structures collées : collage à chaud, sous vide, sous pression,...

Un but de la présente invention est de pallier l'un des inconvénients précités en proposant notamment une intégration spécifique d'étapes après mise en contact pour l'obtention d'un collage direct amélioré. A cet effet, la présente invention concerne un procédé de collage direct entre un premier substrat comprenant une première couche d'un premier matériau et un second substrat comprenant une seconde couche d'un second matériau, le premier matériau et le second matériau étant de natures différentes et choisis parmi des alliages d'éléments des colonnes III et V, le procédé comprenant les étapes de :

a) Fournir le premier substrat et le second substrat,
b) Mettre en contact intime le premier substrat et le second substrat de sorte à former une interface de collage entre la première couche et la seconde couche,
c) Effectuer un premier traitement thermique à une première température prédéfinie sur une première durée prédéterminée,
d) Amincir l'un des substrats parmi le premier substrat et le second substrat,
e) Déposer, à une température inférieure ou égale à la première température prédéfinie, une couche barrière, sur le premier substrat aminci ou sur le second substrat aminci, et

f) Effectuer un second traitement thermique à une seconde température prédéfinie, supérieure à la première température prédéfinie, sur une seconde durée prédéterminée.

Ainsi, l'utilisation d'une couche barrière et d'un double recuit de consolidation des collages, associés selon une intégration spécifique à des étapes de collage et d'amincissement, permet de réaliser un collage direct amélioré. L'étape b) de mise en contact permet d'initier le collage direct. Ce dernier est notamment initié en rapprochant les surfaces du premier substrat et du second substrat jusqu'à réduire leur distance à seulement quelques nanomètres. L'étape c) permet d'effectuer une première consolidation du collage direct à une première température n'affectant pas ou peu les substrats par les contraintes liées à la différence de coefficient de dilatation thermique des matériaux. Cette première consolidation permet d'atteindre une stabilité suffisante de l'interface de collage pour permettre sa manipulation. Il est alors possible d'appliquer de nouveaux procédés sur la structure collée et de réaliser notamment l'étape d) d'amincissement de l'un des deux substrats. Cet amincissement permet d'obtenir la structure composite visée par l'invention, constituée d'un film mince III-V reporté sur un substrat III-V. Par ailleurs l'amincissement permet de réduire l'énergie élastique stockée de la structure collée liée à la différence de dilatation des matériaux lorsque le collage est soumis à de grandes amplitudes thermiques. Ainsi, la structure est moins fragile après amincissement. La couche barrière déposée sur le substrat aminci selon l'étape e), par exemple par PECVD (acronyme anglais de Plasma Enhanced Chemical Vapor Déposition), CVD (Chemical Vapor Déposition) ou PVD (Physical Vapor Déposition), respecte la première température prédéfinie, pour ne pas altérer le collage et notamment de sorte à prévenir l'apparition de bulles à l'interface de collage.

Cette couche barrière a pour effet de limiter le piégeage d'espèces gazeuses au niveau de l'interface de collage lors de la réalisation du second traitement thermique selon l'étape f). En effet, des espèces, par exemple le O, H, C, N mais aussi en quantité minime l'Ar, Ne, He, Kr, et/ou le Xe, sont présentes dans l'atmosphère et dans les structures collées, et peuvent diffuser dans les matériaux jusqu'à atteindre l'interface de collage lorsque des températures élevées sont atteintes.

La présence de ces espèces à l'interface de collage est susceptible d'altérer la qualité du collage. La couche barrière doit présenter une épaisseur suffisante, au moins 100 nm, pour être efficace et former une protection efficace contre la diffusion des espèces vers l'interface de collage. Elle est formée sur la surface du substrat aminci qui est la plus susceptible d'interagir avec l'interface de collage, de par sa proximité. Enfin, le second traitement thermique selon l'étape f) effectué à une seconde température prédéfinie plus élevée que la première température et permet le renforcement de l'énergie de collage entre la première couche et la seconde couche. Du fait de la couche barrière, la seconde température utilisée peut par exemple atteindre 600°C, sans risque de piégeage trop important d'espèces gazeuses à l'interface de collage ou de générer des contraintes liées à la différence de dilatation des matériaux du fait que l'un des substrats est aminci ou d'éviter la dégradation du film mince (évaporation P,...). Ce second traitement thermique à 600°C permet également de réduire la résistivité électrique de l'interface de collage.

Il est entendu dans le présent document que le collage direct est un collage par adhésion moléculaire, opposé au collage utilisant des couches d'adhésifs, polymère, glue, cire, dépôt de couche métallique, etc,.. De même, il est entendu dans la présente demande que le collage direct de la première couche avec la deuxième couche est réalisé par contact directement entre le premier matériau et le second matériau, comme il peut être obtenu par l'intermédiaire d'une couche dite de collage, telle qu'une couche d'oxyde de silicium, présente à l'interface et susceptible de générer beaucoup de liaisons hydrophiles à l'interface, facilitant l'initiation du collage. Le matériau de la couche de collage peut être du $SiO_2$ ou bien un autre matériau choisi pour ses propriétés adaptées aux applications ultérieures visées, notamment en matière de transparence optique et de conductivité électrique. Dans le cas du SiO2, on limitera l'épaisseur à quelques nanomètres (typiquement moins de 6 nm) afin de conserver une conduction électrique suffisante. Lorsque la couche de collage doit être optiquement transparente, elle est formée en un matériau qui n'absorbe pas aux longueurs d'onde concernées dans les applications ultérieures. Dans le domaine photovoltaïque par exemple la couche de collage peut être formée d'alliage binaire, ternaire ou quaternaire d'éléments des groupes III et V.

Selon une disposition, le premier matériau et le second matériau sont choisis parmi le GaAs et l'InP. Il est en effet connu que des espèces, notamment l'oxygène et l'hydrogène, sont capables de diffuser par exemple dans l'InP ou le GaAs lors de recuits à hautes températures, notamment au delà de 300°C.

Avantageusement, la première température prédéfinie est inférieure ou égale à 300°C.

De préférence, la seconde température prédéfinie est supérieure à 300°C, et de préférence encore la seconde température prédéfinie est comprise ente 500 et 600°C.

Selon une possibilité, l'étape d) d'amincissement comprend une étape d'amincissement du premier substrat ou du deuxième substrat, jusqu'à atteindre une épaisseur de la première couche ou de la deuxième couche comprise entre 1 nanomètre et 10 micromètres préférentiellement entre 10 nanomètres à 5 micromètres, typiquement autour de 1,5 micromètres.

Selon une autre possibilité, le premier substrat est formé par la première couche et le second substrat est formé par la seconde couche. Dans cette configuration, l'étape d) consiste ainsi à amincir la première couche ou la seconde couche.

Selon les matériaux considérés, l'étape d) est avantageusement réalisée par polissage mécano-chimique (CMP), par gravure chimique ou par implantation d'espèces ioniques suivi d'une fracture ou une combinaison de ces techniques.

Bien entendu, le premier matériau et le second matériau peuvent être dopés préalablement à l'étape a).

De préférence, l'étape b) de mise en contact est réalisée sous une atmosphère comprenant une teneur en $H_2O$ inférieure à 40% RH, inférieure à 5 ppm et de préférence anhydre, et/ou sous vide. Ces conditions permettent en effet d'éviter un décollement du fait du dégazage massif d'H2 et des contraintes liées aux différences de CTE.

La pression sous vide est au plus de 0.1 mbar et de préférence inférieure ou égale à $5.10^{-2}$ mbar.

L'atmosphère anhydre comprend une teneur en $H_2O$ inférieure à 0.5 ppm.

Selon une configuration, l'étape c) de premier traitement thermique est réalisée sous flux gazeux, tel qu'un flux de $N_2$ ou d'Ar.

Il est possible d'appliquer le premier traitement thermique sous vide ou à pression atmosphérique.

Selon une disposition, l'étape f) de second traitement thermique est réalisée à une seconde température comprise supérieure à 300 et de préférence entre 500 et 600°C.

De préférence, l'étape f) d'application d'un second traitement thermique est réalisée dans la même atmosphère que le premier traitement thermique.

Avantageusement, le premier traitement thermique de l'étape c) et/ou le second traitement thermique de l'étape f) sont réalisées sur une durée comprise entre 10 mn et 5 heures et de préférence sur une durée d'environ 1h à 2h.

Afin d'optimiser l'effet de la couche barrière, celle-ci comprend une ou plusieurs couches empilées de différents matériaux de barrière. L'expression 'matériaux de barrière' signifie qu'il s'agit des matériaux utilisés dans la couche barrière.

De préférence la couche barrière présente une épaisseur supérieure ou égale à 100 nanomètres, et encore de préférence, la couche barrière présente une épaisseur comprise entre environ 100 nm et 1 micromètre.

En effet, une telle couche barrière permet de diminuer de 90% la quantité de gaz présente à l'interface de collage et donnant lieu à la formation de bulles dans la première ou seconde couche transférée.

Cette quantité de gaz est évaluée à partir de la mesure des dimensions des bulles (hauteur, diamètre) et de leur densité, par exemple en utilisant un profilomètre optique. La quantité de gaz présente dans les bulles se calcule en deux temps :

1- Calcul de la pression dans chaque bulle par l'équation de Timoshenko (on présente ici une forme simplifiée de l'équation dans le cadre d'un même matériau pour le substrat et le couche) :

$$D = \frac{3(1-v^2)PR^4}{16E\,e^3}$$ avec D : hauteur de la bulle, R : rayon de la bulle, e : épaisseur du film transférée, E et v : paramètres mécaniques du film, P : pression dans la bulle.

2- Calcul de la quantité de gaz $n_{gaz}$ dans chaque bulle par l'équation de la loi des gaz parfaits :

$$PV = n_{gaz}\,kT$$ Avec V : volume de la bulle, T : température ambiante, $n_{gaz}$ : le nombre de particules, k : constante de Boltzmann

La quantité totale de gaz présente dans les bulles correspond à la somme de la quantité de gaz présente dans chaque bulle.

De préférence les matériaux de barrière sont choisis parmi un oxyde de silicium, un oxynitrure de silicium, un nitrure de silicium, un verre et de l'alumine, tels que le $SiO_2$, $Si_xO_yN_z$ et $Al_2O_3$. Ces matériaux peuvent être utilisés seuls ou en combinaison. D'autres matériaux conventionnellement utilisés pour éviter la décomposition ou l'oxydation thermique du GaAs ou de l'InP peuvent également être utilisés, avantageusement ils pourront servir de couche supplémentaire en plus des matériaux cités précédemment qui seront en contact direct avec la couche amincie. Des techniques de dépôts utilisées et la nature des matériaux de barrière ou « encapsulant » sont notamment référencées dans l'article de K. D. Oberstar et al., « Thin film encapsulants for annealing GaAs and InP", Thin Solid Films, 103 (1983) 17-26.

Avantageusement, la composition chimique peut varier au cours du dépôt de la couche barrière par modification des gaz précurseurs afin d'adapter la couche pour éviter l'endommagement du matériau sur lequel elle est déposée lors de sa formation et de son retrait. Par exemple la couche barrière est déposée initialement sous forme de SixOyNz pour évoluer jusqu'à atteindre la stœchiométrie du $Si_3N_4$.

Selon une configuration le procédé comprend après l'étape f) une étape g) de retrait de la couche barrière. La méthode de retrait et la nature des matériaux de barrière sont choisies de sorte à ne pas laisser de résidus en surface ou de défauts. De même, ce retrait est réalisé dans des conditions permettant de prévenir la détérioration des propriétés physique et électrique de la couche sous-jacente.

Avantageusement, l'étape g) de retrait de la couche barrière est obtenue par gravure, notamment en utilisant une solution aqueuse d'HF dont la concentration est comprise entre 10 et 49%. Ces conditions permettent un retrait simple et efficace. Généralement, le retrait réalisé avec ce réactif est obtenu en moins de 10 minutes, ce qui limite l'endommagement éventuel du matériau sous-jacent.

Selon une première disposition le premier substrat et/ou le second substrat sont massifs.

Selon une variante, le procédé comprend avant l'étape a), une étape i) d'implantation d'espèces ioniques dans le premier substrat ou le second substrat de sorte à former un plan de fragilisation dans le premier substrat ou le second substrat, délimitant un film et un négatif, le film comportant au moins respectivement la première couche ou la seconde couche. Ainsi, lors de la réalisation de l'étape b) un substrat fragilisé est mis en contact avec un autre substrat non fragilisé pour initier le collage. Ensuite, une simple fracture du substrat fragilisé permet l'amincissement selon l'étape d) de l'invention et le transfert d'un film comportant la première couche ou la seconde couche. Le négatif récupéré est alors recyclé pour une nouvelle utilisation et diminuer les coûts de fabrication.

Avantageusement, la fracture du plan de fragilisation séparant le film du négatif est réalisée par le premier traitement thermique de l'étape c). Ainsi l'exécution de l'étape c) permet la réalisation simultanée de l'étape d).

Dans ces conditions, l'étape d) d'amincissement comprend une étape de polissage d'une portion endommagée du film par l'implantation d'espèces ioniques à l'étape i).

Dans une deuxième variante de réalisation, le procédé comprend avant l'étape a) :

- une étape j) comportant la fourniture d'un substrat source comportant un plan de fragilisation formé par implantation d'espèces ioniques, le plan de fragilisation délimitant de part et d'autre un négatif et une couche mince comprenant au moins la première couche ou au moins la seconde couche, et,
- une étape jj) de transfert de la couche mince sur un substrat temporaire de sorte à former le premier substrat ou le second substrat fourni à l'étape a).

Il est entendu que le transfert selon l'étape jj) est réalisé classiquement par mise en contact de l'au moins une couche mince et du substrat temporaire et par l'application d'un traitement thermique permettant la fracture du substrat source au niveau du plan de fragilisation. Lorsque le premier matériau est en GaAs ou en InP, le matériau du substrat temporaire est choisi pour présenter des CTE proches, tel que le saphir, le molybdène ou le GaAs...

Selon une possibilité, l'étape jj) de transfert comprend la mise en contact de la première couche ou de la seconde couche avec le substrat temporaire par l'intermédiaire d'une interface de collage comprenant une couche sacrificielle.

Dans cette disposition, la couche sacrificielle est configurée pour permettre le détachement ultérieur du substrat temporaire et du film lorsque le film est collé au premier substrat ou au second substrat. Par exemple la couche sacrificielle est formée d'un matériau absorbant à une longueur d'onde à laquelle le substrat temporaire est transparent. L'irradiation de la couche sacrificielle à la longueur d'onde d'absorption à travers le substrat temporaire permet le détachement de ce dernier.

Avantageusement, l'interface de collage comprend une première couche de collage et une seconde couche de collage s'étendant respectivement de part et d'autre de la couche sacrificielle. Ainsi, la première ou deuxième couche sous-jacente n'est pas endommagée par l'énergie calorifique dégagée lors de l'absorption du rayonnement par la couche sacrificielle.

Selon une autre possibilité, l'étape jj) comprend le transfert de la première couche ou de la seconde couche et d'au moins une couche active épitaxiée sur la première couche ou la seconde couche de sorte que le premier substrat ou le second substrat fourni à l'étape a) comprend un empilement comportant un substrat temporaire, au moins une couche active épitaxiée et respectivement la première couche ou la seconde couche. La structure obtenue comprend ainsi une interface de collage entre les matériaux des colonnes III et V souhaités et une ou plusieurs couches actives épitaxiées dans de bonnes conditions sur la première ou seconde couche servant de germe. Il est par exemple possible de former des jonctions pour des cellules photovoltaïques par ce biais.

Selon une troisième alternative, le procédé comprend avant l'étape a), une étape ii) de fabrication du premier substrat ou du second substrat comportant :

- une épitaxie d'au moins une couche active sur une plaquette, et
- une épitaxie sur l'au moins une couche active, respectivement, de la première couche en premier matériau ou de la seconde couche en second matériau.

Ainsi le premier ou le second substrat fourni à l'étape a) du procédé comprend respectivement la première couche ou la seconde couche et au moins une couche active.

Avantageusement, la plaquette comprend le premier matériau ou le second matériau. La plaquette sert de germe pour l'épitaxie de l'au moins une couche active et du fait de la nature de son matériau, identique à celui de la première couche ou de la seconde couche, elle ne génère pas de contraintes supplémentaires liées à la différence de dilatation des matériaux.

De préférence, l'étape ii) comprend une étape d'épitaxie d'une couche d'arrêt de gravure sur la plaquette avant l'épitaxie de l'au moins une couche active. Cette configuration permet de faciliter l'amincissement par gravure du premier ou du second substrat.

Avantageusement, lorsque que la plaquette est en GaAs, la couche d'arrêt de gravure est constituée de GaInP.

De préférence, le procédé comprend avant l'étape a) une étape iii) de préparation au collage du premier substrat et du second substrat, notamment par un nettoyage dans un bain d'une solution humide choisie parmi le (NH4)$_2$S, HF, NH$_4$OH, H$_2$SO$_4$ et/ou par un traitement par plasma d'espèces ioniques à base de SF$_6$, N$_2$, O$_2$ des surfaces des premiers et seconds substrats à coller.

Le nettoyage chimique est notamment réalisé pendant 10 à 60 min et de préférence pendant environ 40 min.

Lorsque le nettoyage est effectué dans un bain de (NH4)$_2$S, par exemple à 20%, les substrats sont rincés à l'eau, brossés et/ou séchés avant mise en contact selon l'étape b).

D'autres aspects, buts et avantages de la présente invention apparaîtront mieux à la lecture de la description suivante de plusieurs modes de réalisation de celle-ci, donnée à titre d'exemples non limitatifs et faite en référence aux dessins annexés. Les figures ne respectent pas nécessairement l'échelle de tous les éléments représentés de sorte à améliorer leur lisibilité. Des traits pointillés sont utilisés sur les figures de sorte à illustrer un plan de fragilisation. Dans la suite de la description, par souci de simplification, des éléments identiques, similaires ou équivalents des différentes formes de réalisation portent les mêmes références numériques.

Les figures 1 à 7 illustrent le procédé de collage direct selon un premier mode de réalisationde l'invention.

Les figures 8 à 11 illustrent une variante des premières étapes du procédé selon un second mode de réalisation de l'invention.

Les figures 12 à 15 illustrent une autre variante des premières étapes du procédé selon un troisième mode de réalisation de l'invention.

Les figures 16 à 19 illustrent encore une autre variante des premières étapes du procédé selon un quatrième mode de réalisation de l'invention.

Les figures 20 à 23 illustrent le procédé selon un autre mode de réalisation de l'invention.

Les figures 24 à 27 illustrent encore une autre variante de réalisation du procédé selon l'invention.

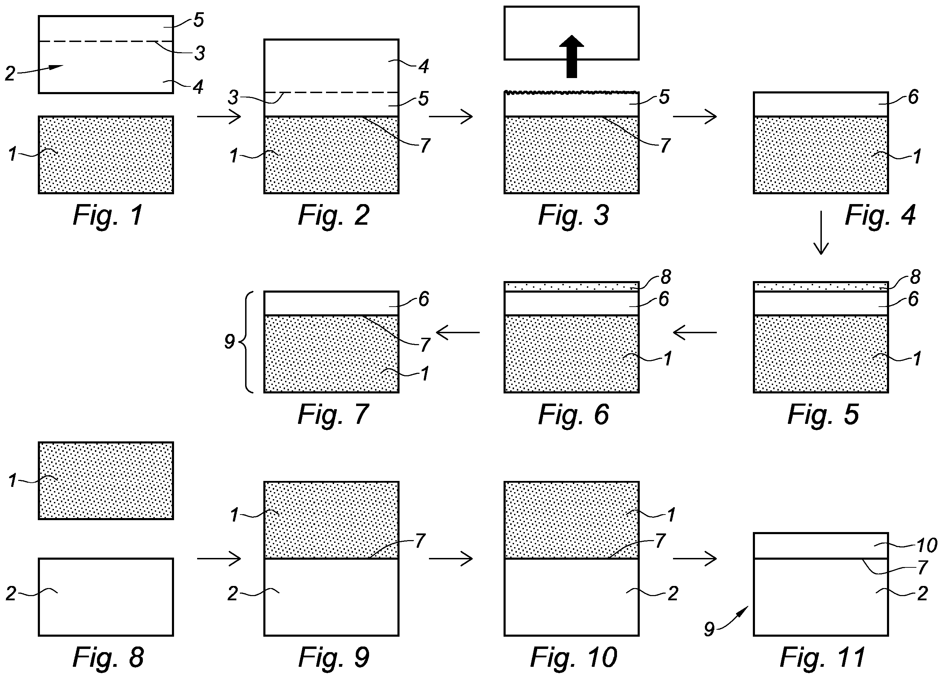

Comme illustré à la figure 1, le procédé comprend une étape a) de fourniture d'un premier substrat 1 massif en GaAs dopé n avec du silicium (1$^E$17 à 1$^E$19/cm3) et d'un second substrat 2 en InP dopé de type n avec du soufre (1$^E$17at/cm$^3$ à 1$^E$19 at/cm$^3$). Au préalable, une étape i) d'implantation d'espèces ioniques à base d'hydrogène est réalisée dans le second substrat 2 avec une dose de 6.5$^E$16 H/cm$^2$ et une énergie d'environ 100 KeV à une température d'environ 150°C. Cette étape conduit à la formation d'un plan de fragilisation 3 délimitant un négatif 4 en InP et un film 5 comprenant une seconde couche 6 en second matériau d'InP d'une épaisseur de l'ordre de 780 nm. Puis une étape ii) de nettoyage est réalisée en plongeant le premier substrat 1 et le second substrat 2 dans un bain d'une solution de (NH4)$_2$S à 20% pendant une durée comprise entre 10 et 60 min, suivi d'un rinçage à l'eau et d'un brossage et/ou d'un séchage. Une fois ces substrats 1,2 préparés au collage, ils sont mis en contact intime sous vide moyen, entre 0.1 et 0.05 mbar, pour former une interface de collage 7 (figure 2) selon l'étape b) du procédé. Selon une possibilité (non illustrée) une couche de collage est déposée préalablement au nettoyage sur le premier substrat 1 et /ou le second substrat 2 avant la mise en contact. L'étape c) d'application du premier traitement thermique est ensuite réalisée à 275°C pendant une première durée comprise entre 1h30 et 2h30. Cette étape de recuit du collage provoque également l'amincissement du second substrat 2 selon l'étape d) par fracture au niveau du plan de fragilisation 3 (figure 3). L'étape d) est ensuite complétée par polissage mécano-chimique de la portion du film 5 endommagée par l'implantation ionique. Comme illustré à la figure 4, il est obtenu un film 5 d'InP d'une épaisseur d'environ 400 nm formant la seconde couche 6, transféré sur le premier substrat 1 massif de GaAs. Avantageusement le négatif 4 du second substrat 2 en InP est recyclé pour un nouveau transfert de couche. Une couche barrière 8 constituée de SiO$_2$ est déposée sur la seconde couche 6 avec une épaisseur de 500 nm (étape e), figure 5). Le dépôt est effectué par PECVD avec un précurseur à base de SiH4 et une température dans la gamme de 200-300°C. Puis un second traitement thermique est effectué selon une étape f) à 600°C sous flux d'azote pendant une seconde durée d'environ 2 heures (figure 6). Une fois le recuit de stabilisation du collage effectué, une étape g) de retrait de la couche barrière 8 est effectuée. L'empilement formé par les précédentes étapes est placé dans un bain d'HF à 20% pendant 1 à 2 min de sorte à consommer la totalité du SiO$_2$ de la couche barrière 8. Une structure finale 9 de type InPo-GaAs (pour InP on GaAs- figure 7) est alors obtenue avec une quantité de gaz présent dans les défauts de 1.16$^E$11 at/cm2 contre 1.16$^E$12 at/cm2 obtenu lorsque la couche barrière 8 est absente.

Les figures 8 à 11 illustrent un autre mode de réalisation du procédé comportant la fourniture de deux substrats 1,2 massifs selon l'étape a) (figure 8), la mise en contact pour initier le collage direct selon l'étape b) (figure 9), l'application du premier traitement thermique selon l'étape c) (figure 10), et l'étape d'amincissement d) du premier substrat 1 par rectification, avant finition par gravure par voie chimique, avec par exemple un réactif à base de NH$_4$OH/H$_2$O$_2$ lorsque la première couche 10 un premier matériau de GaAs (figure 11). Les étapes e), f) et g) du procédé sont ensuite réalisées de manière similaire à celle décrite ci-dessus. Une structure finale 9 du type GaAsoInP est alors obtenue.

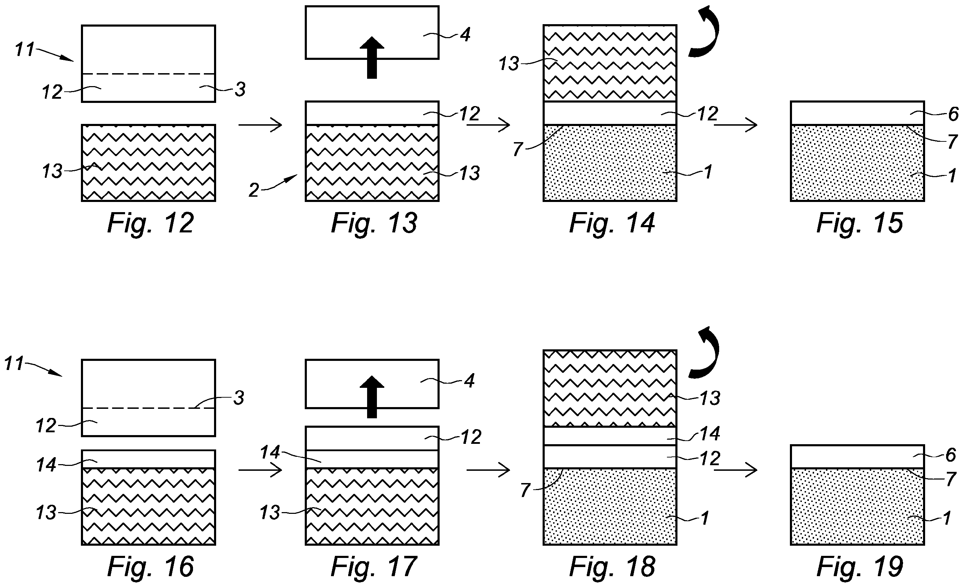

Les figures 12 à 15 illustrent un mode de réalisation qui diffère des précédents los de la fabrication du premier substrat 1 ou du second substrat 2. Selon une étape j) du procédé, un substrat source 11 en InP a été implanté par des espèces ioniques de sorte à former un plan de fragilisation 3 délimitant un négatif 4 et une couche mince 12 comportant la seconde couche 6 en InP. Un substrat temporaire 13 est mis en contact avec la couche mince 12 pour un collage puis une fracture au niveau du plan de fragilisation 3 est réalisée, permettant le transfert de la couche mince 12 sur le substrat temporaire 13 (étape jj) - figure 13) de sorte à fournir le second substrat 2. Puis, une mise en contact avec le premier substrat 1 en GaAs est réalisée selon l'étape b) (figure 14) suivi d'un premier traitement thermique de stabilisation du collage selon l'étape c). Enfin, le substrat temporaire 13 est retiré selon l'étape d) d'amincissement du second substrat 2 comportant la seconde couche 6 (figure 15). Les étapes e), f) et g) du procédé sont ensuite réalisées de manière similaire à celle décrite ci-dessus.

Les figures 16 à 19 illustrent un mode de réalisation voisin de celui décrit précédemment. La différence réside en ce qu'à l'étape jj), le substrat temporaire 13 est mis en contact avec la couche mince 12, par l'intermédiaire d'une couche sacrificielle 14 (figure 16) pemettant de faciliter l'amincissement de l'étape d) du procédé (figure 18), la dégradation de la couche sacrificielle entrainant la désolidarisation du substrat temporaire 13. Par exemple, si le substrat temporaire 13 est un saphir, la couche sacrificielle 14 est avantageusement en un matériau absorbant à une longueur d'onde à laquelle le saphir est transparent, tel que le SixNyHz. Dans ce cas de figure, une irradiation laser de la couche sacrificielle 14 à partir de la face arrière du substrat temporaire 13 transparent permet le détachement selon la technologie du laser lift-off.

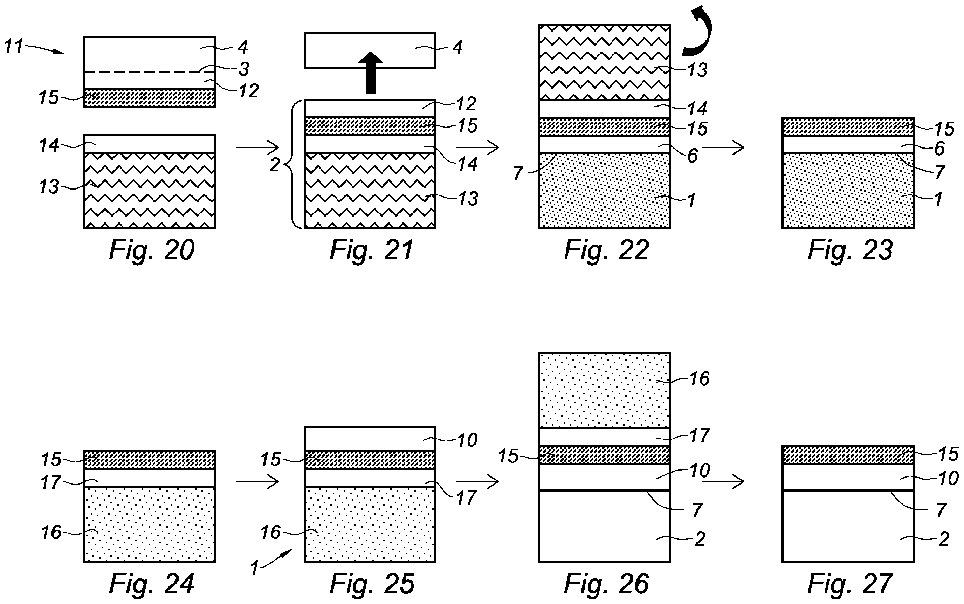

Selon encore une autre variante de réalisation illustrée aux figures 20 à 23, au moins une couche active 15 est épitaxiée sur le substrat source 11 en InP avant implantation par des espèces ioniques formant un plan fragilisation 3. Ce plan de fragilisation 3 délimite de part et d'autre un négatif 4 du substrat source 11 et une couche mince 12 comprenant au moins la seconde couche 6 et la au moins une couche active épitaxiée 15 (étape jj) figure 20). Puis, la fabrication du second substrat 2 est effectuée tel que précédemment décrit en relation avec les figures 16 à 19. L'au moins une couche active 15 est mise en contact avec un substrat temporaire 13 par l'intermédiaire d'une couche sacrificielle 14 pour un collage direct (figure 21). Selon une possibilité, la couche sacrificielle 14 est enterrée dans une couche de collage, par exemple en oxyde de silicium (non illustrée). Puis la fracture est initiée dans le substrat source 11 de sorte à fournir le second substrat 2 selon l'étape a), comprenant un empilement ayant de la base vers la surface : un substrat temporaire 13, une couche sacrificielle 14, au moins une couche active 15 et une seconde couche 6 d'InP (figure 21). Puis les étapes de mise en contact avec le premier substrat 1 de GaAs selon l'étape b) et de premier traitement thermique sont illustrées à la figure 22. Le substrat temporaire 13 est enfin retiré selon l'étape d) d'amincissement du second substrat 2 (figue 23) avant de réaliser les étapes e) à g).

Selon encore une autre alternative, la fabrication du premier substrat 1 est réalisée en fournissant une plaquette 16 de GaAs sur laquelle une couche d'arrêt de gravure 17 en GaInP est épitaxiée. Puis une épitaxie d'une pluralité de couches actives 15 est réalisée jusqu'à environ une épaisseur de 5 micromètres, sur la couche d'arrêt de gravure 17 (figure 24) en vue de la fabrication d'une cellule photovoltaïque, de couches formant des jonctions par exemple à base de GaInAsP, GaInAs, GaInP... Enfin, la première couche 10 de GaAs est formée sur la pluralité de couches actives 15 (figure 25). Puis une étape ii) de préparation au collage du premier substrat 1 et du second substrat 2 en InP est réalisé par un nettoyage dans un bain d'une solution aqueuse de $(NH4)_2S$ à 20% pendant environ 40 min, suivi d'un rinçage à l'eau et d'un brossage, de sorte à réaliser l'étape a) de fourniture du premier substrat 1 et du second substrat 2.

L'étape b) est ensuite réalisée par mise en contact intime de la première couche 10 de GaAs et du second substrat 2 sous un vide inférieur ou égal à 0.1mbar (figure 26). L'étape c) de premier traitement thermique est appliquée à une température comprise entre 250°C et 285°C pendant une première durée comprise entre 1h30 et 2h30.

L'étape d) d'amincissement du premier substrat 1 est réalisée par une gravure chimique sélective avec une solution à base de $NH_4OH/H_2O_2$ qui est stoppée sur la couche d'arrêt de gravure 17. Celle-ci est également éliminée par gravure chimique sélective (figure 27).

Les étapes e) à g) du procédé sont ensuite réalisées comme précédemment décrit (se reporter aux figures 5 à 7). Une étape e) de dépôt d'une couche barrière 8 est réalisée par dépôt par PECVD à une température comprise entre 200 et 300°C. Cette couche barrière 8 est formée d'oxynitrure SixOyNz avec une épaisseur d'environ 100 nm sur le premier substrat 1 aminci et d'une couche de $SiO_2$ avec une épaisseur d'environ 500 nm. L'étape f) de second traitement thermique est réalisée à environ 500°C sous flux d'azote pendant environ 2 heures, et l'étape g) de retrait de la couche barrière 8 est réalisée par gravure en utilisant une solution aqueuse d'HF pendant une durée typiquement comprise entre 1 min et 30 minutes, par exemple 5 minutes. Il a été estimé selon les moyens de calcul précités que la quantité de gaz présente dans le défauts est de $1.806^E12$ at./$cm^2$ contre $2.84^E13$ at./$cm^2$ obtenue en absence de couche barrière 8.

Les étapes décrites ci-dessus appliquées au second substrat 2 et à la seconde couche 6 d'InP peuvent être réalisées sur le premier substrat 1 et la première couche 10 de GaAs et réciproquement.

Ainsi, la présente invention apporte une amélioration déterminante à l'état de la technique antérieure en proposant une séquence de collage notamment entre de l'InP et du GaAs permettant de réaliser des collages sans défauts macro ou microscopiques tout en assurant une bonne conduction électrique verticale et une parfaite transparence optique.

Il va de soi que l'invention n'est pas limitée aux modes de réalisation décrits ci-dessus à titre d'exemples mais qu'elle est définie par les revendicatins suivantes.

**Revendications**

1. Procédé de collage direct entre un premier substrat (1) comprenant une première couche (10) d'un premier matériau et un second substrat (2) comprenant une seconde couche (6) d'un second matériau, le premier matériau et le second matériau étant de natures différentes et choisis parmi des alliages d'éléments des colonnes III et V, le procédé comprenant les étapes de :

    a) Fournir le premier substrat (1) et le second substrat (2),
    b) Mettre en contact le premier substrat (1) et le second substrat (2) de sorte à former une interface de collage (7) entre la première couche (10) et la seconde couche (6),
    c) Effectuer un premier traitement thermique à une première température prédéfinie sur une première durée prédéterminée,
    d) Amincir l'un des substrats parmi le premier substrat (1) et le second substrat (2),
    e) Déposer, à une température inférieure ou égale à la première température prédéfinie, une couche barrière (8), sur le premier substrat (1) aminci ou sur le second substrat (2) aminci, et
    f) Effectuer un second traitement thermique à une seconde température prédéfinie, supérieure à la première température prédéfinie, sur une seconde durée prédéterminée.

2. Procédé de collage direct selon la revendication 1, dans lequel le premier matériau et le second matériau sont choisis parmi le GaAs et l'InP.

3. Procédé de collage direct selon la revendication 2, dans lequel la première température prédéfinie est inférieure ou égale à 300°C.

4. Procédé de collage direct selon l'une des revendication 2 à 3, dans lequel la seconde température prédéfinie est supérieure à 300°C, et de préférence la seconde température prédéfinie est comprise ente 500 et 600°C.

5. Procédé de collage direct selon l'une des revendications 1 à 4, dans lequel l'étape b) de mise en contact est réalisée sous une atmosphère comprenant une teneur en $H_2O$ inférieure à 40% RH, de préférence inférieure à 5 ppm, et de préférence encore sous atmosphère anhydre.

6. Procédé de collage direct selon l'une des revendications 1 à 5, dans lequel l'étape b) de mise en contact est réalisée sous vide.

7. Procédé de collage direct selon l'une des revendications 1 à 6, dans lequel l'étape c) de premier traitement thermique est réalisée sous flux gazeux, tel qu'un flux de $N_2$ ou d'Ar.

8. Procédé de collage direct selon l'une des revendications 1 à 7, dans lequel la couche barrière (8) comprend une ou plusieurs couches empilées de différents matériaux de barrière notamment choisis parmi un oxyde de silicium, un oxynitrure de silicium, un nitrure de silicium, un verre et de l'alumine.

9. Procédé de collage direct selon l'une des revendications 1 à 8, comprenant après l'étape f), une étape g) de retrait de la couche barrière (8).

10. Procédé de collage direct selon l'une des revendications 1 à 9, dans lequel le procédé comprend avant l'étape a), une étape i) d'implantation d'espèces ioniques dans le premier substrat (1) ou le second substrat (2) de sorte à former un plan de fragilisation (3) dans le premier substrat (1) ou le second substrat (2), délimitant un film (5) et un négatif (4), le film (5) comportant au moins respectivement la première couche (10) ou la seconde couche (6).

11. Procédé de collage direct selon la revendication 10, dans lequel une fracture du plan de fragilisation (3) séparant le film (5) du négatif (4) est réalisée par le premier traitement thermique de l'étape c) et dans lequel l'étape d) d'amincissement comprend une étape de polissage d'une portion endommagée du film (5) par l'implantation d'espèces ioniques de l'étape i).

12. Procédé de collage direct selon l'une des revendications 1 à 11, dans lequel le procédé comprend avant l'étape a) :

    - une étape j) comportant la fourniture d'un substrat source (11) comportant un plan de fragilisation (3) formé par implantation d'espèces ioniques, le plan de fragilisation (3) délimitant de part et d'autre un négatif (4) et une couche mince (12) comprenant au moins la première couche (10) ou au moins la seconde couche (6) et,
    - une étape jj) de transfert de la couche mince (12) sur un substrat temporaire (13) de sorte à former le premier substrat (1) ou le second substrat (2) fourni à l'étape a), de préférence par l'intermédiaire d'une interface de collage (7) comprenant une couche sacrificielle (14).

13. Procédé de collage direct selon la revendication 12, dans lequel l'étape jj) comprend le transfert de la première couche (10) ou de la seconde couche (6) et au moins une couche active (15) épitaxiée sur la première couche (10) ou la seconde couche (6) de sorte que le premier substrat (1) ou le second substrat (2) fourni à l'étape a) comprend un empilement comportant un substrat temporaire (13), au moins une couche active (15) épitaxiée et respectivement la première couche (10) ou la seconde couche (6).

14. Procédé de collage direct selon l'une des revendications 1 à 13, dans lequel le procédé comprend avant l'étape a) une étape ii) de fabrication du premier substrat (1) ou du second substrat (2) comportant :

   - une épitaxie d'au moins une couche active (15) sur une plaquette (16), et
   - une épitaxie sur l'au moins une couche active (15) de, respectivement, la première couche (10) en premier matériau ou de la seconde couche (6) en second matériau.

15. Procédé de collage direct selon la revendication 14, dans lequel l'étape ii) comprend une étape d'épitaxie d'une couche d'arrêt de gravure (17) sur la plaquette (16) avant l'épitaxie de l'au moins une couche active (15).

**Patentansprüche**

1. Verfahren zum direkten Bonden zwischen einem ersten Substrat (1), das eine erste Schicht (10) eines ersten Materials umfasst, und einem zweiten Substrat (2), das eine zweite Schicht (6) eines zweiten Materials umfasst, wobei das erste Material und das zweite Material unterschiedlicher Art sind und aus den Legierungen von Elementen der Spalten III und V ausgewählt sind, wobei das Verfahren die folgenden Schritte umfasst:

   a) Bereitstellen des ersten Substrats (1) und des zweiten Substrats (2),
   b) Inkontaktversetzen des ersten Substrats (1) und des zweiten Substrats (2), so dass eine Bondingschnittstelle (7) zwischen der ersten Schicht (10) und der zweiten Schicht (6) gebildet wird,
   c) Durchführen einer ersten thermischen Behandlung bei einer ersten vorher festgelegten Temperatur während einer ersten vorher festgelegten Dauer,
   d) Verschlanken eines der Substrate von dem ersten Substrat (1) und dem zweiten Substrat (2),
   e) Aufbringen, bei einer Temperatur unter oder gleich der ersten vorher festgelegten Temperatur, einer Barriereschicht (8) auf das erste verschlankte Substrat (1) oder auf das zweite verschlankte Substrat (2), und
   f) Durchführen einer zweiten thermischen Behandlung bei einer zweiten vorher festgelegten Temperatur, die höher als die erste vorher festgelegte Temperatur ist, während einer zweiten vorher festgelegten Dauer.

2. Verfahren zum direkten Bonden nach Anspruch 1, wobei das erste Material und das zweite Material aus GaAs und InP ausgewählt sind.

3. Verfahren zum direkten Bonden nach Anspruch 2, wobei die erste vorher festgelegte Temperatur niedriger oder gleich 300 °C ist.

4. Verfahren zum direkten Bonden nach einem der Ansprüche 2 bis 3, wobei die zweite vorher festgelegte Temperatur höher als 300 °C ist und vorzugsweise die zweite vorher festgelegte Temperatur zwischen 500 und 600 °C liegt.

5. Verfahren zum direkten Bonden nach einem der Ansprüche 1 bis 4, wobei der Schritt b) des Inkontaktversetzens in einer Atmosphäre, die einen Gehalt an $H_2O$ unter 40 % RH, vorzugsweise unter 5 ppm, umfasst und vorzugsweise noch in wasserfreier Atmosphäre durchgeführt wird.

6. Verfahren zum direkten Bonden nach einem der Ansprüche 1 bis 5, wobei der Schritt b) des Inkontaktversetzens im Vakuum durchgeführt wird.

7. Verfahren zum direkten Bonden nach einem der Ansprüche 1 bis 6, wobei der Schritt c) der ersten thermischen Behandlung im Gasstrom wie beispielsweise einem $N_2$- oder Ar-Strom durchgeführt wird.

8. Verfahren zum direkten Bonden nach einem der Ansprüche 1 bis 7, wobei die Barriereschicht (8) eine oder mehrere gestapelte Schichten aus verschiedenen Barrierematerialien umfasst, die insbesondere aus einem Siliciumoxid, einem Siliciumoxinitrid, einem Siliciumnitrid, einem Glas und Aluminiumoxid ausgewählt sind.

9. Verfahren zum direkten Bonden nach einem der Ansprüche 1 bis 8, das nach dem Schritt f) einen Schritt g) des Entfernens der Barriereschicht (8) umfasst.

10. Verfahren zum direkten Bonden nach einem der Ansprüche 1 bis 9, wobei das Verfahren vor dem Schritt a) einen Schritt i) des Implantierens von Ionenspezies in das erste Substrat (1) oder das zweite Substrat (2) umfasst, so dass eine Schwächungsebene (3) im ersten Substrat (1) oder im zweiten Substrat (2) gebildet wird, die eine Folie (5) und ein Negativ (4) begrenzt, wobei die Folie (5) mindestens jeweils die erste Schicht (10) oder die zweite Schicht (6) aufweist.

**11.** Verfahren zum direkten Bonden nach Anspruch 10, wobei ein Bruch der Schwächungsebene (3), die die Folie (5) vom Negativ (4) trennt, durch die erste thermische Behandlung von Schritt c) durchgeführt wird und wobei der Verschlankungsschritt d) einen Polierschritt eines beschädigten Abschnitts der Folie (5) durch Implantieren von Ionenspezies von Schritt i) umfasst.

**12.** Verfahren zum direkten Bonden nach einem der Ansprüche 1 bis 11, wobei das Verfahren vor dem Schritt a) umfasst:

- einen Schritt j), der die Bereitstellung eines Quellsubstrats (11) aufweist, aufweisend eine Schwächungsebene (3), die durch Implantieren von Ionenspezies gebildet ist, wobei die Schwächungsebene (3) auf beiden Seiten ein Negativ (4) und eine Dünnschicht (12) begrenzt, die mindestens die erste Schicht (10) oder mindestens die zweite Schicht (6) umfasst, und
- einen Transferschritt jj) der Dünnschicht (12) auf ein temporäres Substrat (13), so dass das in Schritt a) bereitgestellte erste Substrat (1) oder das zweite Substrat (2) gebildet wird, vorzugsweise durch eine Bondingschnittstelle (7), die eine Opferschicht (14) umfasst.

**13.** Verfahren zum direkten Bonden nach Anspruch 12, wobei der Schritt jj) den Transfer der ersten Schicht (10) oder der zweiten Schicht (6) und mindestens einer aktiven Epitaxieschicht (15) auf die erste Schicht (10) oder die zweite Schicht (6) umfasst, so dass das in Schritt a) bereitgestellte erste Substrat (1) oder das zweite Substrat (2) einen Stapel umfasst, der ein temporäres Substrat (13), mindestens eine aktive Epitaxieschicht (15) und jeweils die erste Schicht (10) oder die zweite Schicht (6) aufweist.

**14.** Verfahren zum direkten Bonden nach einem der Ansprüche 1 bis 13, wobei das Verfahren vor Schritt a) einen Herstellungsschritt ii) des ersten Substrats (1) oder des zweiten Substrats (2) umfasst, aufweisend:

- eine Epitaxie mindestens einer aktiven Schicht (15) auf einer Platte (16), und
- eine Epitaxie auf der mindestens einen aktiven Schicht (15) von jeweils der ersten Schicht (10) aus erstem Material oder der zweiten Schicht (6) aus zweitem Material.

**15.** Verfahren zum direkten Bonden nach Anspruch 14, wobei der Schritt ii) einen Epitaxieschritt einer Gravurstoppschicht (17) auf der Platte (16) vor der Epitaxie der mindestens einen aktiven Schicht (15) umfasst.

**Claims**

**1.** A direct bonding method between a first substrate (1) comprising a first layer (10) of a first material and a second substrate (2) comprising a second layer (6) of a second material, the first material and the second material being of different natures and selected from alloys of elements from columns III and V, the method comprising the steps of:

a) Providing the first substrate (1) and the second substrate (2),
b) Bringing the first substrate (1) into contact with the second substrate (2) so as to form a bonding interface (7) between the first layer (10) and the second layer (6),
c) Performing a first heat treatment at a first predefined temperature over a first predetermined period,
d) Thinning one of the substrates among the first substrate (1) and the second substrate (2),
e) depositing, at a temperature lower than or equal to the first predefined temperature, a barrier layer (8), on the thinned first substrate (1) or on the thinned second substrate (2), and
f) Carrying out a second heat treatment at a second predefined temperature, higher than the first predefined temperature, over a second predetermined period.

**2.** The direct bonding method according to claim 1, wherein the first material and the second material are selected from GaAs and InP.

**3.** The direct bonding method according to claim 2, wherein the first predefined temperature is less than or equal to 300 °C.

**4.** The direct bonding method according to any of claims 2 to 3, wherein the second predefined temperature is greater than 300 °C, and preferably the second predefined temperature is comprised between 500 and 600 °C.

**5.** The direct bonding method according to any of claims 1 to 4, wherein step b) of contacting is carried out under an atmosphere comprising a $H_2O$ content of less than 40% RH, preferably less than 5 ppm, and more preferably under an anhydrous atmosphere.

**6.** The direct bonding method according to any of claims 1 to 5, wherein step b) of contacting is carried out under vacuum.

**7.** The direct bonding method according to any of claims 1 to 6, wherein step c) of the first heat treatment is carried out under a gas flow, such as a flow

of $N_2$ or Ar.

8. The direct bonding method according to any of claims 1 to 7, wherein the barrier layer (8) comprises one or more stacked layers of different barrier materials in particular selected from a silicon oxide, a silicon oxynitride, a silicon nitride, a glass and alumina.

9. The direct bonding method according to any of claims 1 to 8, comprising after step f), a step g) of removing the barrier layer (8).

10. The direct bonding method according to any of claims 1 to 9, wherein the method comprises before step a), a step i) of implanting ionic species in the first substrate (1) or the second substrate (2) so as to form a weakening plane (3) in the first substrate (1) or the second substrate (2), delimiting a film (5) and a negative (4), the film (5) including at least respectively the first layer (10) or the second layer (6).

11. The direct bonding method according to claim 10, wherein a fracture of the weakening plane (3) separating the film (5) from the negative (4) is carried out by the first heat treatment of step c) and wherein the step d) of thinning comprises a step of polishing a damaged portion of the film (5) by implanting ionic species from step i).

12. The direct bonding method according to any of claims 1 to 11, wherein the method comprises, before step a):

   - a step j) including the supply of a source substrate (11) including a weakening plane (3) formed by implantation of ionic species, the weakening plane (3) delimiting on either side a negative (4) and a thin layer (12) comprising at least the first layer (10) or at least the second layer (6) and,
   - a step jj) of transferring the thin film (12) onto a temporary substrate (13) so as to form the first substrate (1) or the second substrate (2) provided in step a), preferably via a bonding interface (7) comprising a sacrificial layer (14).

13. The direct bonding method according to claim 12, wherein step jj) comprises the transfer of the first layer (10) or of the second layer (6) and at least one active layer (15) epitaxied on the first layer (10) or the second layer (6) so that the first substrate (1) or the second substrate (2) provided in step a) comprises a stack including a temporary substrate (13), at least one epitaxial active layer (15) and respectively the first layer (10) or the second layer (6).

14. The direct bonding method according to any of claims 1 to 13, wherein the method comprises before step a) a step ii) of manufacturing the first substrate (1) or the second substrate (2) including:

   - an epitaxy of at least one active layer (15) on a wafer (16), and
   - an epitaxy on at least one active layer (15) of, respectively, the first layer (10) of the first material or of the second layer (6) of the second material.

15. The direct bonding method according to claim 14, wherein step ii) comprises a step of epitaxy of an etching stopper layer (17) on the wafer (16) before the epitaxy of at least one active layer (15).

Fig. 1

Fig. 2

Fig. 3

Fig. 4

Fig. 5

Fig. 6

Fig. 7

Fig. 8

Fig. 9

Fig. 10

Fig. 11

EP 3 295 480 B1

EP 3 295 480 B1

Fig. 12

Fig. 13

Fig. 14

Fig. 15

Fig. 16

Fig. 17

Fig. 18

Fig. 19

Fig. 20

Fig. 21

Fig. 22

Fig. 23

Fig. 24

Fig. 25

Fig. 26

Fig. 27

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- *Solid-State Electronics,* 2002, vol. 46, 1103-1108
- **U. GOSELE et al.** SEMICONDUCTOR WAFER BONDING. *ANNUAL REVIEW OF MATERIALS SCIENCE,* 01 Août 1998, vol. 28 (1), 215-241
- **F. DIMROTH et al.** Wafer bonded four-junction GaInP/GaAs//GaInAsP/GaInAs concentrator solar cells with 44.7% efficiency. *Prog. Photovolt: Res. Appl.,* 2014
- **K. D. OBERSTAR et al.** Thin film encapsulants for annealing GaAs and InP. *Thin Solid Films,* 1983, vol. 103, 17-26